# EUROPEAN PATENT APPLICATION

(11) **EP 4 734 367 A1**
(43) Date of publication of application: **29.04.2026**
(21) Application number: 25205903.5
(22) Date of filing: 30.09.2025
(51) Int. Cl.: H03K 5/156

(54) **DUTY CORRECTION CIRCUIT**

(30) Priority: 28.10.2024 KR 20240148272
(71) Applicant: Samsung Electronics Co., Ltd., Suwon-si, Gyeonggi-do 16677 (KR)
(72) Inventor: PARK, Jungyeong, 16677 Suwon-si (KR); NOH, Dongin, 16677 Suwon-si (KR); YOO, Byoung Joo, 16677 Suwon-si (KR); CHOI, Youngho, 16677 Suwon-si (KR); HEO, Donghun, 16677 Suwon-si (KR)
(74) Representative: Marks & Clerk LLP

(57) **Abstract**

A duty correction circuit includes a capacitor to couple an input clock, a buffer chain circuit coupled to the capacitor through a node to output an output clock based on amplifying the coupled input clock, and a feedback circuit coupled to the node and the buffer chain circuit and including a first low-pass filter to filter the output clock, a first chopper circuit to receive a reference voltage and the filtered output clock through first and second inputs, and chop the reference voltage and the filtered output clock, an amplifier to amplify the chopping signals, a second chopper circuit to chop the amplified signals, an integration feedback circuit coupled to the second input and the second chopper circuit, a second low-pass filter coupled to the second chopper circuit, and a feedback path to provide a filtered signal from the second low-pass filter to the node.

## Description

### BACKGROUND

Example embodiments relate to a duty correction circuit.

Clocks are widely utilized in various semiconductor circuits, and the duty cycle of the clocks may have a significant impact on the overall circuit performance. For example, in high-speed interfaces (HSI), limitations such as clock speed and increased power consumption often necessitate (or otherwise, result in) the use of half-rate or quadrature-rate clocks for data processing. However, deviations from a 50% duty cycle in the clocks may degrade circuit performance. Such deviations reduce the overall eye margin of the signal, resulting in increased jitter.

To address the above issue, circuits that are sensitive to clock duty may require (or otherwise, include) a duty correction circuit to autonomously correct the clock duty.

### SUMMARY

Example embodiments provide a duty correction circuit, capable of significantly reducing duty errors.

According to example embodiments, a duty correction circuit includes a first capacitor configured to couple an input clock to obtain a coupled input clock, a buffer chain circuit coupled to the first capacitor through a node, the buffer chain circuit being configured to output an output clock based on amplifying the coupled input clock, and a feedback circuit coupled to the node and the buffer chain circuit, the feedback circuit including a first low-pass filter configured to filter the output clock to obtain a filtered output clock, a first chopper circuit configured to receive a reference voltage through a first input, receive the filtered output clock through a second input, and chop the reference voltage and the filtered output clock to obtain chopping signals, an amplifier configured to amplify the chopping signals to obtain amplified signals, a second chopper circuit configured to chop the amplified signals, an integration feedback circuit coupled to the second input and an output of the second chopper circuit, a second low-pass filter coupled to the output of the second chopper circuit, and a feedback path configured to provide a filtered signal from the second low-pass filter to the node.

According to example embodiments, a duty correction circuit includes a sub-duty correction circuit configured to correct a duty cycle of an input clock to obtain a corrected input clock, a buffer chain circuit configured to output an output clock based on amplifying the corrected input clock, and a feedback circuit coupled to the sub-duty correction circuit and the buffer chain circuit, the feedback circuit including a first low-pass filter configured to filter the output clock to obtain a filtered output clock, a first chopper circuit configured to receive a reference voltage through a first input, receive the filtered output clock through a second input, chop the reference voltage and the filtered output clock to obtain chopping signals, an amplifier configured to amplify the chopping signals to obtain amplified signals, a second chopper circuit configured to chop the amplified signals, an integration feedback circuit coupled to the second input and an output of the second chopper circuit, a second low-pass filter coupled to an output of the second chopper circuit, and a feedback path configured to provide a filtered signal from the second low-pass filter to the sub-duty correction circuit.

According to example embodiments, a duty correction circuit includes a first capacitor configured to couple an input clock, a first inverter comprising an input coupled to the first capacitor through a node, a first resistor coupled to an output of the first inverter, a first switch coupled in series to the first resistor, the first switch being configured to turn on in a first mode, at least one second inverter coupled in series to the output of the first inverter, the at least one second inverter being configured to output an output clock corresponding to the input clock, a first low-pass filter configured to filter the output clock to obtain a filtered output clock, a second switch coupled to an output of the first low-pass filter, the second switch being configured to turn on in a second mode, a first chopper circuit configured to receive a reference voltage through a first input, receive the filtered output clock through a second input, the second input being coupled to the second switch, and chop the reference voltage and the filtered output clock to obtain chopping signals, an amplifier configured to amplify the chopping signals to obtain amplified signals, a second chopper circuit configured to chop the amplified signals, an integration feedback circuit coupled to the second input and an output of the second chopper circuit, a second low-pass filter coupled to the output of the second chopper circuit, a buffer coupled to an output of the second low-pass filter, a third switch coupled in series to an output of the buffer, the third switch being configured to turn on in the second mode, and a third resistor coupled in series to the third switch.

According to example embodiments, a duty correction method includes coupling an input clock signal to obtain a coupled input clock signal, amplifying the coupled input clock signal to obtain an output clock signal, filtering the output clock signal to obtain a filtered output clock signal, chopping the filtered output clock signal and a reference voltage to obtain chopping signals, amplifying the chopping signals to obtain amplified signals, chopping the amplified signals to obtain output signals, and filtering the output signals.

At least some of the above and other features of the invention are set out in the claims.

### BRIEF DESCRIPTION OF DRAWINGS

FIG. 1 is a diagram illustrating a duty correction circuit according to example embodiments.
FIG. 2 is a diagram illustrating a duty correction circuit according to example embodiments.
FIG. 3 is a circuit diagram of a buffer chain circuit according to example embodiments.
FIG. 4 is a circuit diagram of an integration chopping circuit according to example embodiments.
FIG. 5 is a circuit diagram of an integration chopping circuit according to example embodiments.
FIG. 6 is a diagram illustrating a duty correction circuit according to example embodiments.
FIG. 7 is a circuit diagram of a duty correction circuit according to example embodiments.
FIG. 8 is a diagram illustrating an example of the duty cycle of an output clock over time.
FIG. 9 is a diagram illustrating the duty cycle of an output clock over time during offset cancellation according to example embodiments.
FIG. 10 is a diagram illustrating waveforms of chopping signals according to example embodiments.
FIG. 11 is a diagram illustrating a waveform of an output signal of an integration chopping circuit based on integration amplification according to example embodiments.
FIG. 12 is a diagram illustrating the duty cycle of an output clock for each case according to example embodiments.
FIG. 13 is a diagram illustrating a memory system according to example embodiments.
FIG. 14 is a diagram illustrating an electronic device according to example embodiments.
FIG. 15 is a flowchart illustrating a method of correcting a duty of a clock signal according to example embodiments.

### DETAILED DESCRIPTION

Hereinafter, example embodiments will be described with reference to the accompanying drawings.

Hereinafter, in the present application, "duty" may be used interchangeably with "duty cycle" defined as the percentage between a high level and a low level in a periodic signal, and/or "duty ratio" defined as a ratio of a high level to a low level in a periodic signal.

Hereinafter, in the present application, a duty correction circuit correcting duty refers to a circuit configured to correct the duty of an input clock such that the duty of the input clock has a specific value or a specific ratio (for example, the duty of the input clock to have a target duty).

Hereinafter, in the present application, the phrase 'component A and component B are coupled' may encompass both physical and electrical connections.

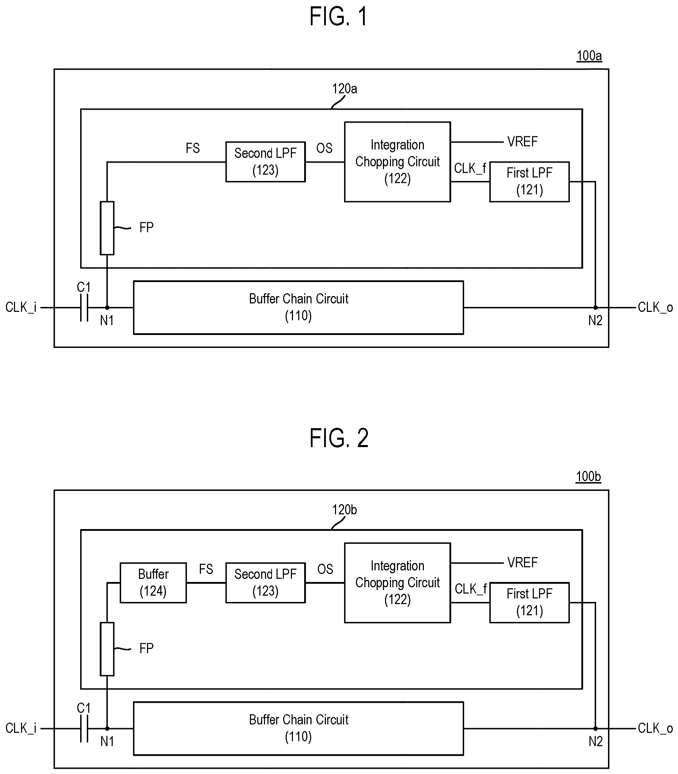

FIG. 1 is a diagram illustrating a duty correction circuit according to example embodiments.

Referring to FIG. 1, a duty correction circuit 100a according to example embodiments may include a first capacitor C1, a buffer chain circuit 110, and/or a feedback circuit 120a.

The first capacitor C1 may be coupled to a first node N1 and may couple an input clock CLK_i. For example, the first capacitor C1 may function as an AC coupling capacitor that couples an alternating current (AC) component from the input clock CLK_i while filtering a direct current (DC) component. For example, a signal at the first node N1 may be a signal with only the AC component remaining from the input clock CLK_i signal, or a signal that is as similar as possible to the AC component.

The buffer chain circuit 110 may be coupled to the first capacitor C1 through the first node N1. The buffer chain circuit 110 may be configured to output an output clock CLK_o based on amplifying a coupled input clock CP_CLK. The buffer chain circuit 110 may be coupled to a second node N2 and may output the output clock CLK_o to the second node N2.

In example embodiments, the buffer chain circuit 110 may include a plurality of inverters. The plurality of inverters may sequentially amplify the coupled input clock CP_CLK.

In example embodiments, the buffer chain circuit 110, in conjunction with the first capacitor C1, may be configured to perform coarse duty correction of the input clock CLK_i. The output clock CLK_o may have a coarsely corrected duty through the first capacitor C1 and the buffer chain circuit 110, but fine duty correction may be performed through the feedback circuit 120a.

The feedback circuit 120a may be coupled to the first node N1 and the buffer chain circuit 110, and may provide feedback from the second node N2 corresponding to an output of the buffer chain circuit 110 to the first node N1 corresponding to an input of the buffer chain circuit 110.

In example embodiments, the feedback circuit 120a may be configured to provide a DC voltage corresponding to a target duty to the first node N1 through the fine duty correction, such that the output clock CLK_o has the target duty. For example, the feedback circuit 120a may be configured as an analog feedback loop.

In example embodiments, the feedback circuit 120a may include a first low-pass filter 121, an integration chopping circuit 122, a second low-pass filter 123, and/or a feedback path FP to perform duty correction.

The first low-pass filter 121 may be configured to filter the output clock CLK_o. For example, the first low-pass filter 121 may retain the DC component (or the DC component and minimal, or a smallest amount of, AC components) in the output clock CLK_o by performing low-pass filtering on the output clock CLK_o. The first low-pass filter 121 may be variously configured to have a specific cutoff frequency for low-pass filtering.

The integration chopping circuit 122 may be configured to receive a reference voltage VREF, and a filtered output clock CLK_f from the first low-pass filter 121, and to perform an integrator operation and a chopping operation based on provided signals. The reference voltage VREF provided to the integration chopping circuit 122 may be set based on the target duty cycle of the input clock CLK_i.

For example, the target duty cycle may be 50%. The reference voltage VREF may be set to a value corresponding to half of a supply voltage for the operation of the duty correction circuit 100a.

According to example embodiments, the feedback circuit 120a may further include components providing a 1/2 supply voltage as the reference voltage VREF to the integration chopping circuit 122. For example, the feedback circuit 120a may further include a distribution network (for example, may be implemented as a network including a plurality of division resistors) to provide the 1/2 supply voltage.

In example embodiments, the integration chopping circuit 122 may correct the duty of the input clock CLK_i by correcting a voltage of the provided filtered output clock CLK_f to be equal to the reference voltage VREF. The integration chopping circuit 122 may output an output signal OS corresponding to the duty correction.

In example embodiments, the integration chopping circuit 122 may chop signals to be processed. It will be understood by those skilled in the art that chopping involves switching signals based on a chopping frequency. For example, the integration chopping circuit 122 may chop the provided reference voltage VREF and the filtered output clock CLK_f. When there is a certain level of offset between the reference voltage VREF and the filtered output clock CLK_f, the filtered output clock CLK_f may toggle by a level corresponding to the offset with respect to the reference voltage VREF.

In example embodiments, the integration chopping circuit 122 may perform integration amplification on the provided reference voltage VREF and the filtered output clock CLK_f. Accordingly, an output signal OS of the integration chopping circuit 122 may be in the form of an integrated signal that follows the trend of the provided signals, rather than achieving full swing.

When the filtered output clock CLK_f toggles through chopping, the output signal OS of the integration chopping circuit 122 may also toggle with respect to a specific voltage. The specific voltage may be a common-mode voltage of the integration chopping circuit 122.

Ultimately, the output signal OS may be output as a result of the duty correction, chopping, and integration amplification of the integration chopping circuit 122 according to the above-described examples. Chopping may cause the offset between the reference voltage VREF and the filtered output clock CLK_f to appear as an AC component with respect to a specific voltage in the output signal OS. Accordingly, when only the specific voltage is filtered, the offset may be cancelled (or reduced).

The second low-pass filter 123 may be coupled to the output of the integration chopping circuit 122. By performing low-pass filtering on the output signal OS of the integration chopping circuit 122, the second low-pass filter 123 may retain the DC component (or the DC component and a minimal, or a smallest, AC component) in the output signal OS of the integration chopping circuit 122. The second low-pass filter 123 may be variously configured to have a specific cutoff frequency for low-pass filtering.

As described above, the output of the integration chopping circuit 122 toggles with respect to a specific voltage, so that the signal FS filtered through the second low-pass filter 123 may have a DC component (or the DC component and a minimal, or a smallest, AC component) corresponding to the specific voltage. As a result, the offset may be cancelled (or reduced) to disappear in the filtered signal FS.

The feedback path FP may be configured to provide the filtered signal FS from the second low-pass filter 123 to the first node N1. The first node N1 may have a voltage corresponding to the filtered signal FS as a DC component through the feedback path FP. Accordingly, the first node N1 may have an AC component coupled through the first capacitor C1 and a DC component provided through the feedback circuit 120a. In addition, the output clock CLK_o may have a corrected duty.

The duty correction circuit 100a according to the above-described examples may prevent (or reduce) errors that may occur due to offset during duty correction by cancelling (or reducing) the offset, which may occur between the reference voltage VREF and the filtered output clock CLK_f provided for duty correction, through chopping. In addition, the duty correction circuit 100a may maintain the linearity of amplification by preventing (or reducing) the output signal OS of the integration chopping circuit 122 from full-swinging through the integration amplification operation.

FIG. 2 is a diagram illustrating a duty correction circuit according to example embodiments. Hereinafter, detailed descriptions of configurations already described in FIG. 1 will be omitted.

Referring to FIG. 2, a feedback circuit 120b included in a duty correction circuit 100b according to example embodiments may further include a buffer 124 in addition to the duty correction circuit of FIG. 1.

The buffer 124 may be coupled to an output of the second low-pass filter 123 and the feedback path FP. For example, the buffer 124 may be a unitary gain buffer.

According to the above-described examples, the second low-pass filter 123 may be configured to filter the DC component (or the DC component and a minimal, or a smallest, AC component) corresponding to a specific voltage from the output signal OS of the integration chopping circuit 122. When the second low-pass filter 123 is provided, a parasitic capacitance component may occur in a path between the output of the second low-pass filter 123 and the first node N1.

In addition, the first node N1 has an AC component coupled through the first capacitor C1, so that isolation from the filtered signal FS corresponding to the DC component may be required (or otherwise, implemented).

Accordingly, in example embodiments, the buffer 124 may be provided between the second low-pass filter 123 and the feedback path FP to prevent (or reduce) degradation caused by the parasitic capacitance component and provide isolation (or at least partial isolation) between the second low-pass filter 123 and the feedback path FP.

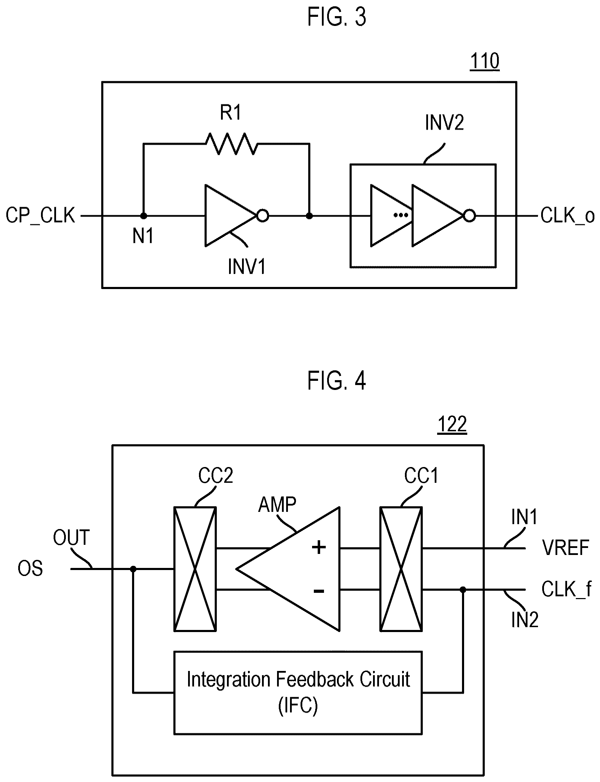

FIG. 3 is a circuit diagram of a buffer chain circuit according to example embodiments.

Referring to FIG. 3, the buffer chain circuit 110 according to example embodiments may include a first resistor R1 and a plurality of inverters. The plurality of inverters may include a first inverter INV1 and one or more second inverters INV2.

The first inverter INV1 may include an input coupled to the first node N1. The first resistor R1 may be coupled to an output of the first inverter INV1 and the first node N1 to provide resistive feedback to the first inverter INV1. According to the above-described examples, an input clock CP_CLK with the AC component coupled may be provided to the first node N1 (through a capacitor). The first inverter INV1 and the first resistor R1 may coarsely correct the duty of the coupled input clock CP_CLK through the resistive feedback.

One or more second inverters INV2 may be included in the buffer chain circuit 110. The one or more second inverters INV2 may be coupled in series to an output of the first inverter INV1. The one or more second inverters INV2 may amplify an output signal OS of the first inverter INV1 to output an output clock CLK_o. The output clock CLK_o may have a larger swing level through the buffer chain circuit 110.

FIG. 4 is a circuit diagram of an integration chopping circuit according to example embodiments.

Referring to FIG. 4, the integration chopping circuit 122 according to example embodiments may include a first chopper circuit CC1, an amplifier AMP, a second chopper circuit CC2, and/or an integration feedback circuit IFC.

The first chopper circuit CC1 may receive a reference voltage VREF through a first input IN1 and receive a filtered output clock CLK_f through a second input IN2. The second input IN2 may be connected to a first low-pass filter according to the above-described examples (for example, FIGS. 1 and 2).

The first chopper circuit CC1 may be configured to chop the provided reference voltage VREF and filtered output clock CLK_f. The chopping may enable the reference voltage VREF and the filtered output clock CLK_f to be alternately applied to the two inputs (a non-inverting input terminal and an inverting input terminal) of the amplifier AMP. The first chopper circuit CC 1 may output chopping signals based on the chopping to the two inputs of the amplifier AMP.

The amplifier AMP may be configured to amplify the chopping signals provided from the first chopper circuit CC1 and output amplified signals corresponding to the amplification.

In example embodiments, the amplifier AMP may be configured such that two inputs of the amplifier AMP are virtually shorted during an amplification operation. The virtual short may cause the voltage difference between the reference voltage VREF, provided to the non-inverting input terminal through the first input (IN1), and the filtered output clock CLK_f, provided to the inverting input terminal through the second input (IN2), to approach zero. Accordingly, the voltage of the filtered output clock CLK_f may have a value equal to or significantly close to the reference voltage VREF (duty correction).

The amplifier AMP may include amplifying elements including transistors. Due to manufacturing process variations of the elements inside the amplifier AMP, random mismatch may occur in the amplifier AMP. The random mismatch may cause an offset between the two inputs of the amplifier AMP. When an offset is present, an error may occur in the output clock CLK_o in spite of the duty correction of the above-described amplifier AMP.

The second chopper circuit CC2 may be coupled to the two outputs of the amplifier AMP. The second chopper circuit CC2 may be configured to chop the amplified signals. The second chopper circuit CC2 may output an output signal OS based on chopping through an output OUT. The second chopper circuit CC2 may be connected to opposite ends of the amplifier AMP along with the first chopper circuit CC1, allowing the amplifier AMP to operate as negative feedback.

The integration feedback circuit IFC may be coupled to the second input IN2 and the output OUT of the second chopper circuit CC2, and may be configured to allow the amplifier AMP to operate as an integrator. Accordingly, the output signal OS of the integration chopping circuit 122 may be prevented from excessively swinging (or the excessive swinging may be reduced). According to example embodiments, the first chopper circuit CC1 and/or the second chopper circuit CC2 may be implemented consistent with chopper circuits as would be understood by a person of ordinary skill in the art.

The operations of the first chopper circuit CC1, the amplifier AMP, the second chopper circuit CC2, and the integration feedback circuit IFC described above are as follows. The first chopper circuit CC1 may receive the reference voltage VREF for duty correction through the first input IN1 and receive the filtered output clock CLK_f through the second input IN2. The first chopper circuit CC1 may perform chopping on the reference voltage VREF and the filtered output clock CLK_f, and the chopping signals may be provided to the two inputs of the amplifier AMP. The filtered output clock CLK_f may toggle with respect to the reference voltage VREF. The toggling may occur through chopping to cancel (or reduce) an offset that may be present between the two inputs of the amplifier AMP. The offset may be further mitigated through subsequent low-pass filtering.

The amplifier AMP operates as an integrator due to the integration feedback circuit IFC. The amplifier AMP may be configured to virtually short two inputs thereof. This configuration corrects the filtered output clock CLK_f to the reference voltage VREF. By configuring the amplifier AMP with its two inputs virtually shorted, the filtered output clock CLK_f may be corrected to the reference voltage VREF.

The second chopper circuit CC2 may perform chopping on the two outputs of the amplifier AMP corresponding to the duty correction. The output signal OS resulting from the chopping of the second chopper circuit CC2 may not achieve full swing through the integration feedback circuit IFC. Accordingly, the linearity of the amplifier AMP may be preserved or improved.

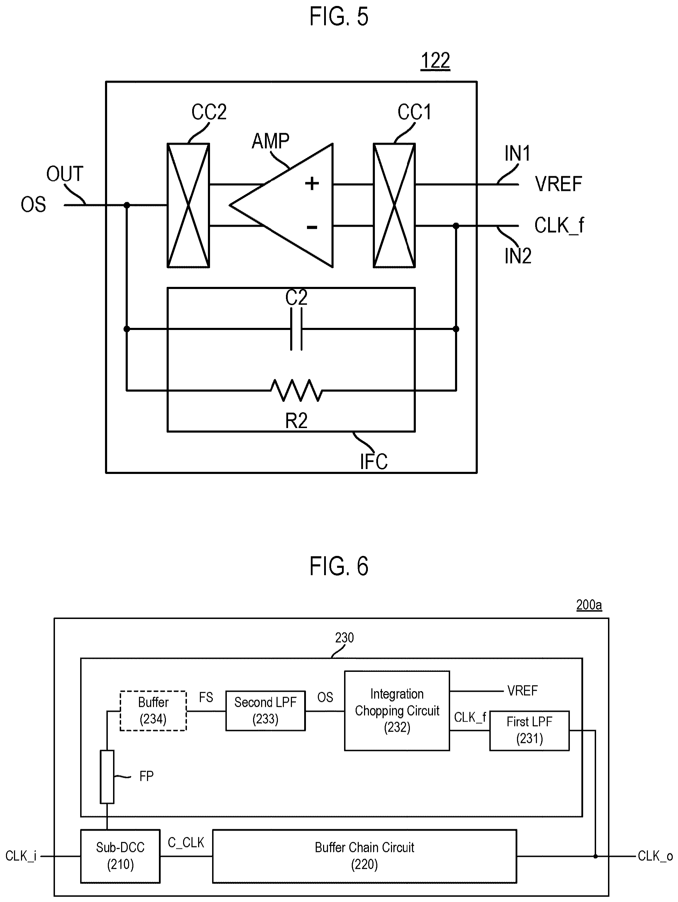

FIG. 5 is a circuit diagram of an integration chopping circuit according to example embodiments. Hereinafter, detailed descriptions of configurations already described in FIG. 4 will be omitted.

Referring to FIG. 5, the integration feedback circuit IFC of the integration chopping circuit 122 according to example embodiments may include a second capacitor C2 and a second resistor R2.

The second capacitor C2 may be coupled to a second input IN2 and an output OUT of the second chopper circuit CC2. The second capacitor C2 may operate as a feedback element of an amplifier AMP. A second resistor R2 may be coupled in parallel to the second capacitor C2. The second resistor R2 may be coupled in parallel to the second capacitor C2 to prevent the second capacitor C2 from operating as an open circuit at DC (or reduce the occurrence thereof).

The integration feedback circuit IFC may provide the second capacitor C2 and the second resistor R2 as feedback elements of the amplifier AMP, causing the amplifier AMP to operate as an integrator. The output signal OS of the integration chopping circuit 122 may take a form that follows the trend of two inputs of the amplifier AMP, rather than achieving full swing due to the integration amplification operation.

FIG. 6 is a diagram illustrating a duty correction circuit according to example embodiments.

Referring to FIG. 6, a duty correction circuit 200a according to example embodiments includes a sub-duty correction circuit 210, a buffer chain circuit 220, and/or a feedback circuit 230.

The sub-duty correction circuit 210 may be configured to coarsely correct the duty of a provided input clock CLK_i.

In example embodiments, the sub-duty correction circuit 210 may include a coupling capacitor for coupling an AC component of an input clock CLK_i (for example, the first capacitor of FIGS. 1 and 2) and configurations for correcting a DC component of a coupled input clock (for example, the first inverter and the second resistor of FIG. 3). The configurations for correcting the DC component may include various configurations, capable of providing resistive feedback to the coupled input clock.

In addition, the sub-duty correction circuit 210 may be variously configured to correct the DC component of the input clock CLK_i to have a value closer to a target duty.

The buffer chain circuit 220 may include one or more inverters and output an output clock CLK_o based on amplifying the input clock C_CLK corrected through the sub-duty correction circuit 210.

The feedback circuit 230 may include a first low-pass filter 231, an integration chopping circuit 232, a second low-pass filter 233, and/or a feedback path FP. According to example embodiments, a buffer 234 may be further provided between the second low-pass filter 233 and the feedback path FP.

The feedback circuit 230 may correct the duty more finely than the sub-duty correction circuit 210. In example embodiments, the first low-pass filter 231 may filter the output clock CLK_o. The integration chopping circuit 232 corrects a duty by correcting the filtered output clock CLK_f to have the same level as (or a similar level to) the reference voltage VREF. In the duty correction process, chopping may be performed to cancel (or reduce) the offset between the reference voltage VREF and the filtered output clock CLK_f. An output signal OS of the integration chopping circuit 232 may not achieve full swing through integration amplification. The second low-pass filter 233 may filter the output signal OS of the integration chopping circuit 232.

When a buffer is configured according to example embodiments, the buffer 234 may buffer a filtered signal FS and provide the feedback path FP, which provides isolation between the second low-pass filter 233 and the feedback path FP.

The sub-duty correction circuit 210 may receive the DC component corresponding to the filtered signal FS through the feedback path FP to correct the duty of the input clock CLK_i to the target duty.

The duty correction circuit 200a according to the above-described examples may correct the duty of the output clock CLK_o to the target duty. Also, the duty correction circuit 200a may cancel (or reduce) the offset, which may occur between the reference voltage VREF and the filtered output clock CLK_f, through chopping to prevent errors from occurring (or reduce the occurrence of the errors) in the corrected duty of the output clock CLK_o. Also, the duty correction circuit may prevent the output signal OS from achieving full swing (or reduce the occurrence thereof) through integration amplification. Also, the duty correction circuit may provide isolation between the second low-pass filter 233 and the feedback path FP through the buffer.

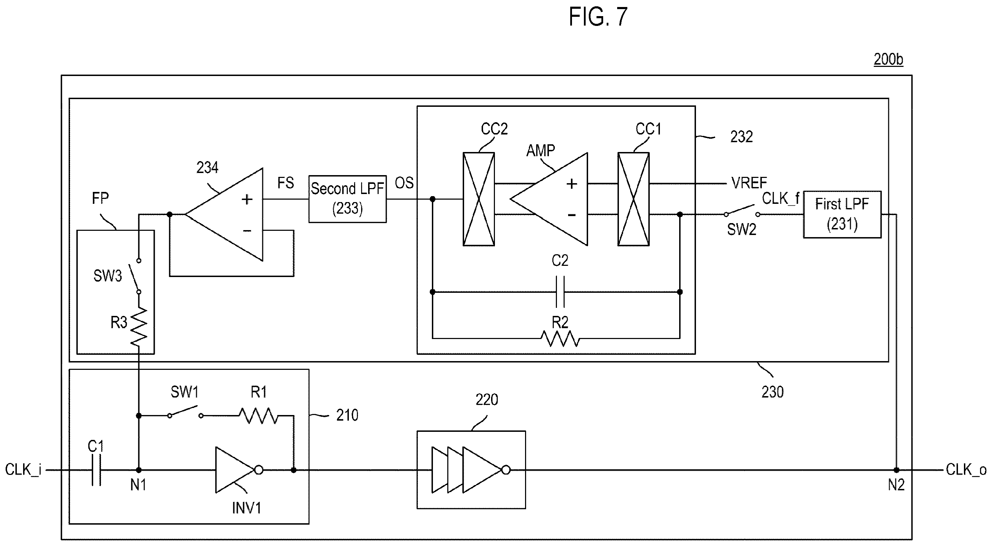

FIG. 7 is a circuit diagram of a duty correction circuit according to example embodiments.

Referring to FIG. 7, a duty correction circuit 200b according to example embodiments may include a sub-duty correction circuit 210, a buffer chain circuit 220, a first low-pass filter 231, an integration chopping circuit 232, a second low-pass filter 233, a buffer 234, and/or a feedback path FP. The duty correction circuit 200b may further include first to third switches SW1 to SW3 for controlling a path.

The sub-duty correction circuit 210 according to example embodiments may include a first capacitor C1, a first resistor R1, and/or a first switch SW1. The first capacitor C1 may couple the input clock CLK_i through AC coupling. The first inverter INV1 may include an input coupled to the first capacitor C1 through the first node N1. The first resistor R1 may be coupled to an output of the first inverter INV1.

The first switch SW1 may be coupled in series to the first resistor R1 and may be turned on based on the feedback circuit 230 being deactivated (for example, in a first mode). The first mode may be defined as a mode in which feedback from a second node N2 to the first node N1 is not activated. The first switch SW1 may be turned on in the first mode to provide a feedback loop for the first inverter INV1 (from an output of the first inverter INV1 to the first node N1). When the first switch SW1 is turned on, a DC component caused by resistive feedback may be applied to the first node N1.

The first switch SW1 may be turned off in a second mode. The second mode may be defined as a mode in which feedback from the second node N2 to the first node N1 is activated.

The buffer chain circuit 220 may include one or more second inverters INV2 coupled to the output of the first inverter INV1. The one or more second inverters INV2 may output an output clock CLK_o corresponding to the input clock CLK_i through amplification.

The first low-pass filter 231 may be coupled to the second node N2 and may be configured to filter the output clock CLK_o. The first low-pass filter 231 may perform low-pass filtering on the output clock CLK_o and output a filtered output clock CLK_f.

The second switch SW2 may be coupled to an output of the first low-pass filter 231 and may be turned on to activate the feedback circuit 230 in the second mode. As the second switch SW2 is turned on, the second switch may provide the filtered output clock CLK_f to the second input IN2. The second switch SW2 may be turned off in the first mode.

The first chopper circuit CC1 may receive the reference voltage VREF through the first input IN1 and receive the filtered output clock CLK_f in the second mode through the second input IN2 coupled to the second switch SW2. The first chopper circuit CC1 may chop the provided reference voltage VREF and filtered output clock CLK_f and output the chopped signals to the amplifier AMP.

The amplifier AMP may amplify the chopped signals and output the amplified signals. The amplifier AMP may perform integration amplification on the chopped signals through the integration feedback circuit 230 coupled to the second input IN2 and the output of the second chopper circuit CC2. Two inputs of the amplifier AMP may be virtually shorted to correct a duty. However, due to process variations, an offset caused by random mismatch may be present between the two inputs, but the impact of the offset may be significantly reduced through chopping.

The second chopper circuit CC2, along with the first chopper circuit CC1, may provide negative feedback to the amplifier AMP while simultaneously (or contemporaneously) chopping the amplified signals.

The second low-pass filter 233 may be coupled to the output of the second chopper circuit CC2.

The buffer 234 may be coupled to the output of the second low-pass filter 233. In example embodiments, the buffer 234 may include a first input coupled to the output of the second low-pass filter 233, a second input, and an output coupled to the second input. For example, the first input may be a non-inverting input of the buffer 234, and the second input may be an inverting input of the buffer 234. The second input may be coupled to the output, allowing the buffer 234 to operate as a unity gain buffer.

An offset may also occur in the two inputs of the buffer 234 due to random mismatch. However, since the level of the filtered output clock CLK_f has already been corrected to the level of the reference voltage VREF due to chopping, the offset occurring in the buffer 234 may not affect the duty correction.

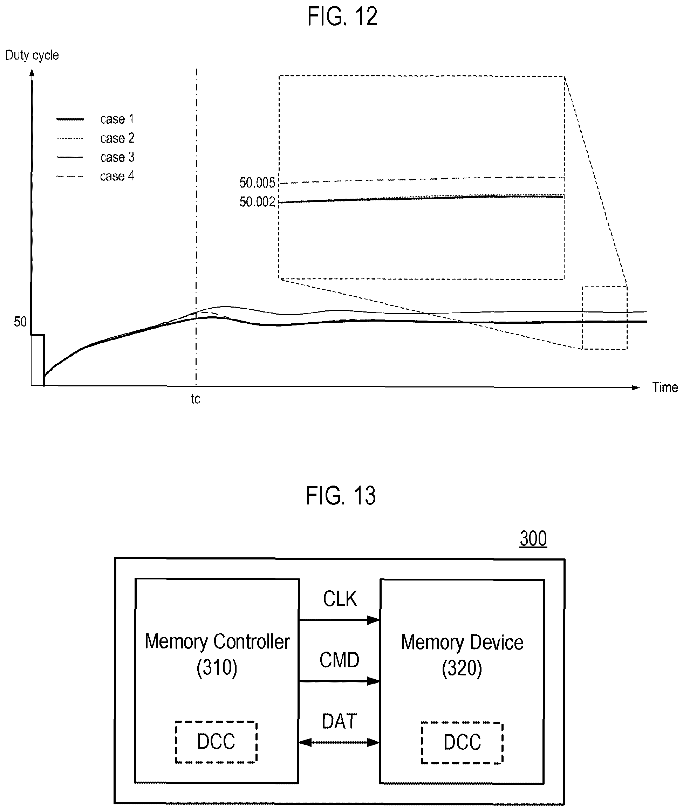

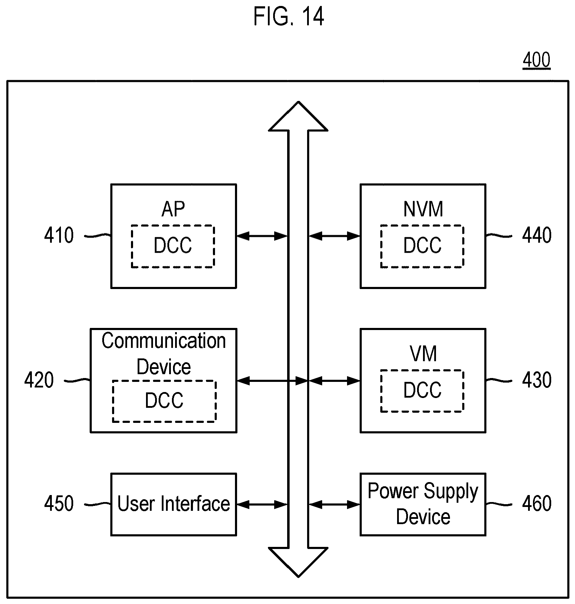

The feedback path FP according to example embodiments may include a third switch SW3 and a third resistor R3. The third switch SW3 may be coupled in series to the output of the buffer 234 and may be turned on to activate the feedback circuit 230 in the second mode. The third switch SW3 may be turned on in the second mode to provide the output of the buffer 234 to the first node N1. The third resistor R3 may be coupled in series to the third switch SW3 and may provide resistive feedback to the first node N1. According to example embodiments, the feedback circuit 230 may be deactivated in the first mode, and/or activated in the second mode, based on control signals supplied to the first switch SW1, the second switch SW2 and/or the third switch SW3 provided by a memory controller 310, a memory device 320, an AP 410, a communication device 420, a volatile memory 430 and/or a non-volatile memory 440 (discussed below in connection with FIGS. 13 and 14). According to example embodiments, the memory controller 310, the memory device 320, the AP 410, the communication device 420, the volatile memory 430 and/or the non-volatile memory 440 (discussed below in connection with FIGS. 13 and 14) may control the first switch SW1, the second switch SW2 and/or the third switch SW3 to activate the feedback circuit 230 in response to determining that the duty of a clock signal deviates from a target duty by at least a threshold amount, and may control the first switch SW1, the second switch SW2 and/or the third switch SW3 to deactivate the feedback circuit 230 in response to determining that the duty of the clock signal does not deviate from the target duty by at least the threshold amount.

An intrinsic bandwidth and a loop bandwidth may be defined in terms of the amplifier AMP of the duty correction circuit 200b. The intrinsic bandwidth may be a bandwidth defined from the two inputs of the amplifier AMP to the output of an amplifier AMP. The loop bandwidth may be a bandwidth defined from the output of the amplifier AMP to the two inputs of the amplifier AMP. For example, the loop bandwidth may be defined through the second low-pass filter 233, the buffer 234, the feedback path FP, the sub-duty correction circuit 210, the buffer chain circuit 220, and the first low-pass filter 231. Accordingly, the loop bandwidth may be slower than the intrinsic bandwidth.

Due to the speed difference between the intrinsic bandwidth and the loop bandwidth, an output signal OS of the integration chopping circuit 232 appears as a signal toggling between high and low levels with full swing, similar to an output signal OS of an open-loop amplifier. Therefore, it may be difficult to maintain the linearity of the amplifier AMP due to excessive swing. The non-linearity may cause an error in the signal FS filtered through the second low-pass filter 233.

Accordingly, the duty correction circuit 200b may operate the amplifier AMP as an integrator through the integration feedback circuit 230 to reduce a swing of the output signal OS. The swing of the output signal OS may be reduced to preserve (or improve) the linearity of the amplifier AMP.

The duty correction circuit 200b according to the above-described embodiments may correct the duty of the input clock CLK_i to the target duty through the virtual short of the amplifier AMP. Also, the duty correction circuit 200b may cancel (or reduce) an offset, which may occur due to random mismatch between the two inputs of the amplifier AMP, to prevent errors from occurring (or reduce the occurrence of errors) in the corrected duty of the output clock CLK_o. Also, the duty correction circuit 200b may prevent (or reduce) chopping errors that may occur as an output magnitude of the amplifier AMP moves outside the range in which the linearity of the amplifier is ensured (or increased). This may be achieved through integral amplification, compensating for the speed difference between the inherent bandwidth of the amplifier AMP and the loop bandwidth (for example, the slower speed of the loop bandwidth). Also, the duty correction circuit 200b may provide isolation between the second low-pass filter 233 and the feedback path FP through the buffer 234.

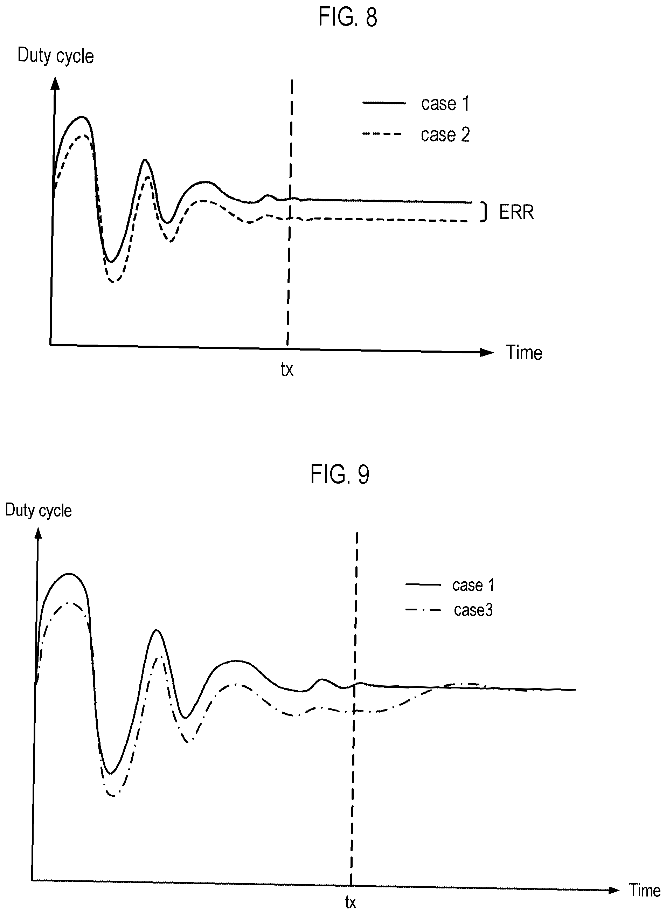

FIG. 8 is a diagram illustrating an example of the duty cycle of an output clock over time.

FIG. 8 illustrates the duty cycle of an output clock for two cases: (Case 1) an ideal case in which no offset is present between the two inputs of an amplifier, and (Case 2) a case in which an offset is present. In both cases, the duty cycle fluctuates until time tx at which the amplifier is settled.

After time tx, a duty cycle converges to a value corresponding to a target duty in Case 1, while a duty cycle converges to a value different from the target duty by an error value ERR in Case 2.

FIG. 9 is a diagram illustrating the duty cycle of an output clock over time during offset cancellation according to example embodiments.

FIG. 9 illustrates the duty cycle of an output clock for two cases: (Case 1) an ideal case in which no offset is present between two inputs of an amplifier, and (Case 3) a case in which an offset is present. In both cases, the duty cycle fluctuates until the amplifier is settled at time tx. Case 3 represents an output clock of the duty correction circuit (e.g., the duty correction circuit 100a), capable of cancelling (or reducing) the offset through chopping according to the above-described examples.

After time tx, in both Case 1 and Case 3, the duty cycle converges to a value corresponding to a target duty. In case 3, the duty cycle may converge to the target duty through offset cancellation, similar to the ideal Case 1.

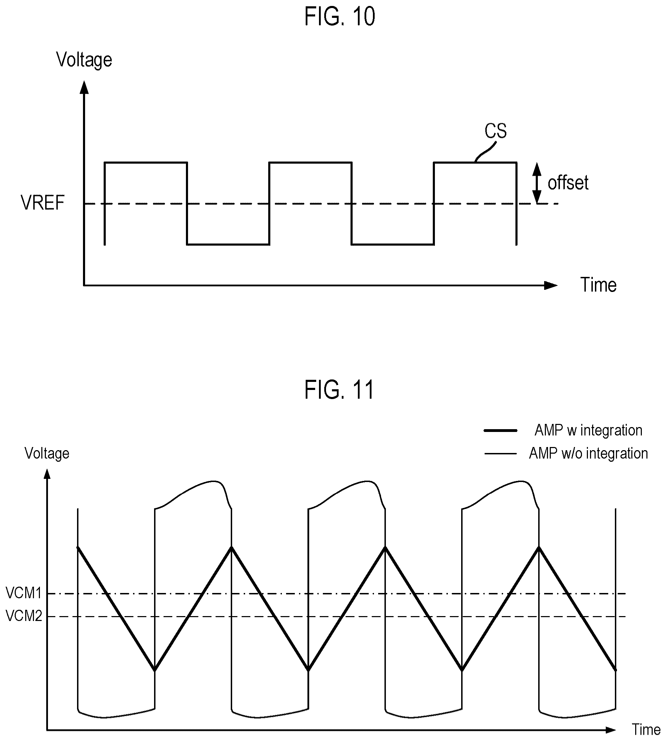

FIG. 10 is a diagram illustrating waveforms of chopping signals according to example embodiments.

Referring to FIG. 10, a chopped signal CS chopped through chopping according to the above-described examples may toggle by the magnitude of an offset with respect to the reference voltage VREF. For example, the chopped signal CS may be a chopped filtered clock signal.

An output signal of an amplifier having the chopped signal CS as an input may have the form of a toggle signal, similarly to the chopped signal CS. However, when the output signal of the amplifier is filtered through low-pass filtering, only a DC component excluding an offset corresponding to a swing may remain. Accordingly, the offset may be cancelled (or reduced).

FIG. 11 is a diagram illustrating a waveform of an output signal of an integration chopping circuit based on integration amplification according to example embodiments.

Referring to FIG. 11, an output of an amplifier without integration (AMP w/o integration) may achieve full swing due to a difference in speed of the bandwidth. For example, the output of the amplifier may exceed the range in which the linearity of the amplifier is maintained. Accordingly, an error may be present in a DC component VCM1 of the output of the amplifier.

The output of the amplifier with integration (AMP w integration) may have a form that follows the trend of two inputs of the amplifier, rather than achieving full swing. For example, the linearity of the amplifier may be maintained. As a result, errors in the DC component VCM2 of the output of the amplifier may be prevented (or reduced).

FIG. 12 is a diagram illustrating the duty cycle of an output clock for each case according to example embodiments.

Referring to FIG. 12, Case 1 is a case in which there is no chopping, buffer offset, or amplifier offset, Case 2 is a case in which there is no chopping or amplifier offset but there is a buffer offset, Case 3 is a case in which there is no chopping but there are a buffer offset and an amplifier offset, and Case 4 is a case in which there are chopping, a buffer offset, and an amplifier offset. In addition, an example is provided in which a target duty is 50%.

In Case 3 in which all offsets are present but no chopping is present, a duty cycle of an output clock deviates significantly from a target duty of 50%, unlike other cases. Therefore, it may be seen that chopping is effective for offset cancellation.

Also, in Case 1 and Case 2 in which only a difference is the presence or absence of buffer offset, it may be seen that duty cycles are almost identical. Therefore, it may be seen that the buffer offset does not affect the performance of the duty correction circuit.

Also, it may be seen that the duty cycle of Case 4, in which all offsets are present, shows almost no difference from the duty cycles of Case 1 and Case 2 that are close to the ideal case (for example, a case in which there is no amplifier offset).

FIG. 13 is a diagram illustrating a memory system according to example embodiments.

Referring to FIG. 13, a memory system 300 according to example embodiments may include a memory controller 310 and/or a memory device 320. For example, each of the memory controller 310 and the memory device 320 may be provided as a single chip, a single package, or a single module. Alternatively, the memory controller 310 and the memory device 320 may be formed as a single chip, a single package, or a single module to be provided as storage such as an embedded memory, a memory card, a memory stick, or a solid-state drive (SSD).

The memory controller 310 may control the overall operation of the memory device 320. The memory controller 310 may be implemented with hardware (for example, a logic circuit), software, firmware, or a combination of hardware, software, and firmware.

The memory controller 310 may transmit a clock signal CLK and/or a command CMD for the operation of the memory device 320 to the memory device 320, or may transmit and receive data DAT to be written or read to and from the memory device 320. The memory controller 310 may write data DAT to the memory device 320 or read data DAT stored in the memory device 320 based on a request of a host. The memory controller 310 may generate, process, and manage commands CMD, addresses, and control signals to access the memory device 320.

The memory device 320 may include volatile memory such as a dynamic random access memory (DRAM) or a static RAM (SRAM), or may include a non-volatile memory such as a flash memory or a resistive memory.

The memory controller 310 may generate a clock signal for the operation of the memory controller 310 and/or the memory device 320. The memory device 320 may generate an internal clock signal of the memory device 320.

According to example embodiments, a duty correction circuit DCC for duty correction of the clock signal may be configured in the memory controller 310 and/or the memory device 320. The duty correction circuit DCC may be configured or operate according to the above-described examples (for example, FIGS. 1 to 7). The duty correction circuit DCC may correct a duty of a clock signal for the operation of the memory controller 310 and/or the memory device 320 to a target duty. According to example embodiments, the duty correction circuit DCC may cancel (or reduce) an offset between inputs of an amplifier inside the duty correction circuit DCC through chopping. Also, the duty correction circuit DCC may preserve (or improve) the linearity of the amplifier through integration amplification. Also, the duty correction circuit DCC may provide isolation between a low-pass filter and a feedback path through the buffer. According to example embodiments, the memory controller 310 and/or the memory device 320 may program and/or read a memory according to the duty-corrected clock signal. For example, the memory controller 310 and/or the memory device 320 may apply a program voltage to one or more transistors in memory to program the one or more transistors to maintain specific program voltages (e.g., based on the manage commands CMD, addresses, and/or control signals) according to a timing provided by the duty-corrected clock signal.

FIG. 14 is a diagram illustrating an electronic device according to example embodiments.

Referring to FIG. 14, an electronic device 400 according to example embodiments may include an application processor (AP) 410, a communication device 420, a volatile memory 430, a non-volatile memory 440, a user interface 450, and/or a power supply device 460.

For example, the electronic device 400 may be any mobile device such as a mobile phone, a smartphone, a personal digital assistant (PDA), a portable multimedia player (PMP), a digital camera, a music player, a portable game console, and/or a navigation system.

The application processor 410 may control the overall operation of the electronic device 400 and may include a single-core processor or a multicore processor. For example, the application processor 410 may have a multicore configuration such as a dual-core configuration, a quad-core configuration, or a hexa-core configuration.

The communication device 420 may perform wireless communication or wired communication with an external device. For example, the communication device 420 may perform Ethernet communication, near field communication (NFC), radio-frequency identification (RFID) communication, mobile telecommunication, memory card communication, universal serial bus (USB) communication, or the like.

The volatile memory 430 may store data processed by the application processor 410 or may operate as working memory. For example, the application processor 410 may be implemented with a dynamic random access memory (DRAM), a static RAM (SRAM), a mobile DRAM, a double data rate (DDR) synchronous DRAM (SDRAM), a low-power DDR (LPDDR) LPDDR SDRAM, a graphics DDR (GDDR) SDRAM, a Rambus DRAM (RDRAM), or a memory similar thereto.

The non-volatile memory 440 may store a boot image for booting the electronic device 400. For example, the non-volatile memory 440 may be implemented with an electrically erasable programmable read-only memory (EEPROM), a flash memory, a phase change random access memory (PRAM), a resistance random access memory (RRAM), a nano floating gate memory (NFGM), a polymer random access memory (PoRAM), a magnetic random access memory (MRAM), a ferroelectric random access memory (FRAM), or a memory similar thereto.

The application processor 410, the communication device 420, the volatile memory 430, and/or the non-volatile memory 440 may include a duty correction circuit DCC according to example embodiments.

In example embodiments, the application processor 410, the communication device 420, the volatile memory 430, and the non-volatile memory 440 may operate in synchronization with a predetermined (or alternatively, given) clock signal and may include a duty correction circuit DCC according to example embodiments to correct the duty of the received clock signal.

The duty correction circuit DCC according to example embodiments may be configured or operate according to the above-described examples (for example, FIGS. 1 to 7). The duty correction circuit DCC may correct a duty of a clock signal for the operation of the application processor 410, the communication device 420, the volatile memory 430, the non-volatile memory 440, or the like, to a target duty. In example embodiments, the duty correction circuit DCC may cancel (or reduce) an offset between inputs of an amplifier inside the duty correction circuit DCC through chopping. Also, the duty correction circuit DCC may preserve (or improve) the linearity of the amplifier through integration amplification. Also, the duty correction circuit DCC may provide isolation between a low-pass filter and a feedback path through the buffer. According to example embodiments, the application processor 410 may execute one or more applications installed on the electronic device 400 according to a timing provided by the duty-corrected clock signal. According to example embodiments, the communication device 420 may generate one or more communication signals based on the duty-corrected clock signal. For example, the communication device 420 may upconvert a baseband frequency (or intermediate frequency) communication signal to obtain a radio frequency (RF) communication signal for transmission outside of the electronic device 400, and/or downconvert an RF communication signal received from outside of the electronic device 400 to obtain a baseband frequency (or intermediate frequency) communication signal. According to example embodiments, the volatile memory 430 and/or the non-volatile memory 440 may program and/or read a memory according to the duty-corrected clock signal. For example, the volatile memory 430 and/or the non-volatile memory 440 may apply a program voltage to one or more transistors in memory to program the one or more transistors to maintain specific program voltages according to a timing provided by the duty-corrected clock signal.

The user interface 450 may include one or more input devices, such as a keypad or a touchscreen, and/or one or more output devices, such as a speaker and a display device. The power supply device 460 may supply an operating voltage of the electronic device 400.

According to example embodiments, the electronic device 400 may further include a camera image processor (CIS) and may further include a storage device such as a memory card, a solid state drive (SSD), a hard disk drive (HDD), or a CD-ROM.

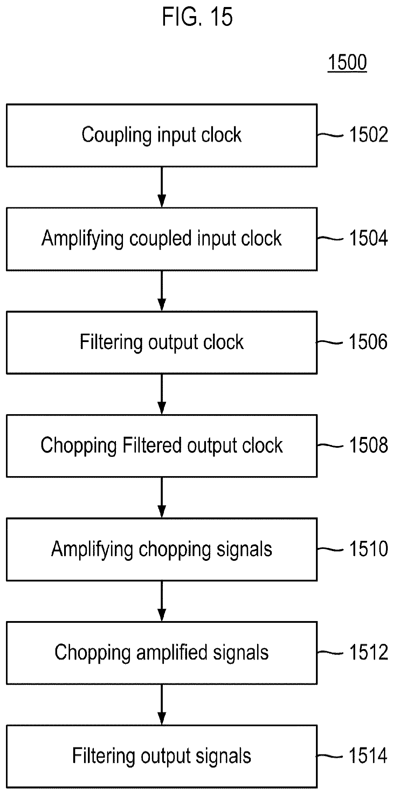

FIG. 15 is a flowchart illustrating a method of correcting a duty of a clock signal according to example embodiments.

Referring to FIG. 15, a method of correcting a duty of a clock signal is provided. The method may be implemented using one or more among the duty correction circuit 100a, the duty correction circuit 200a and/or the duty correction circuit 200b, for example, under the control of the memory controller 310, the memory device 320, the AP 410, the communication device 420, the volatile memory 430 and/or the non-volatile memory 440. In operation 1502, the method includes coupling an input clock signal to obtain a coupled input clock signal. In operation 1504, the method includes amplifying the coupled input clock signal to obtain an output clock signal. In operation 1506, the method includes filtering the output clock signal to obtain a filtered output clock signal. In operation 1508, the method includes chopping the filtered output clock signal and a reference voltage to obtain chopping signals. In operation 1510, the method includes amplifying the chopping signals to obtain amplified signals. In operation 1512, the method includes chopping the amplified signals to obtain output signals. In operation 1514, the method includes filtering the output signals.

As set forth above, according to example embodiments, a duty correction circuit, capable of significantly reducing duty errors, may be provided.

Conventional devices and methods for correcting a duty of a clock signal result in errors in an output clock due to manufacturing process variations of elements inside of an amplifier and failure to maintain amplifier linearity. For example, the manufacturing process variations result in an offset between inputs of the amplifier that causes the errors in the output clock (see, e.g., the discussion of FIGS. 8-9 above). Also, excessive swing in the output of the amplifier is caused by a difference in speed between an intrinsic bandwidth and a loop bandwidth resulting in the failure to maintain amplifier linearity (see, e.g., the discussion of FIG. 11 above). Accordingly, the conventional devices and methods are unable to correct the duty of the clock signal with sufficient efficacy.

However, according to example embodiments, improved devices and methods are provided for correcting a duty of a clock signal. For example, the improved devices and methods may use a first chopper circuit to correct for the offset between the inputs of an amplifier, thereby preventing or reducing the errors in the output clock (see, e.g., the discussion of FIGS. 8-9 above). Also, the improved device and methods may use a second chopper circuit to perform chopping on outputs of the amplifier, thereby preventing or reducing the swing in the output of the amplifier and maintaining (or increasing) the linearity of the amplifier. Accordingly, the improved devices and methods overcome the deficiencies of the conventional devices and methods to at least correct the duty of the clock signal more effectively.

According to example embodiments, operations described herein as being performed by the duty correction circuit 100a, the buffer chain circuit 110, the feedback circuit 120a, the first low-pass filter 121, the integration chopping circuit 122, the second low-pass filter 123, the feedback path FP, the feedback circuit 120b, the duty correction circuit 100b, the buffer 124, the one or more second inverters INV2, the first chopper circuit CC1, the amplifier AMP, the second chopper circuit CC2, the integration feedback circuit IFC, the duty correction circuit 200a, the sub-duty correction circuit 210, the buffer chain circuit 220, the feedback circuit 230, the first low-pass filter 231, the integration chopping circuit 232, the second low-pass filter 233, the duty correction circuit 200b, the sub-duty correction circuit 210, the buffer chain circuit 220, the first low-pass filter 231, the integration chopping circuit 232, the second low-pass filter 233, the buffer 234, the memory system 300, the memory controller 310, the memory device 320, the duty correction circuit DCC, the electronic device 400, the AP 410, the communication device 420, a volatile memory 430, a non-volatile memory 440, a user interface 450, and/or the power supply device 460 may be performed by processing circuitry. The term 'processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), a digital signal processor, a microcomputer, a field programmable gate array (FPGA), a System-on-Chip (SoC), a programmable logic unit, a microprocessor, application-specific integrated circuit (ASIC), etc.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm, and/or functions, described in connection with example embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

While example embodiments have been shown and described above, it will be apparent to those skilled in the art that modifications and variations could be made without departing from the scope of the present inventive concepts as defined by the appended claims.

Embodiments are set out in the following clauses:
Clause 1. A duty correction circuit comprising:
   a sub-duty correction circuit configured to correct a duty cycle of an input clock to obtain a corrected input clock;
   a buffer chain circuit configured to output an output clock based on amplifying the corrected input clock; and
   a feedback circuit coupled to the sub-duty correction circuit and the buffer chain circuit, the feedback circuit including,
      a first low-pass filter configured to filter the output clock to obtain a filtered output clock,
      a first chopper circuit configured to,
         receive a reference voltage through a first input,
         receive the filtered output clock through a second input,
         chop the reference voltage and the filtered output clock to obtain chopping signals,
         an amplifier configured to amplify the chopping signals to obtain amplified signals,
         a second chopper circuit configured to chop the amplified signals,
         an integration feedback circuit coupled to the second input and an output of the second chopper circuit,
         a second low-pass filter coupled to an output of the second chopper circuit, and
         a feedback path configured to provide a filtered signal from the second low-pass filter to the sub-duty correction circuit.
Clause 2. The duty correction circuit of clause 1, wherein
   the sub-duty correction circuit comprises:
   a first capacitor coupled to the feedback path through a node, the first capacitor being configured to couple the input clock;
   a first inverter having an input coupled to the node; and
   a resistor coupled to the node and an output of the first inverter.
Clause 3. The duty correction circuit of clause 2, wherein
   the buffer chain circuit comprises at least one second inverter.
Clause 4. The duty correction circuit of any of clauses 1 to 4, further comprising:
   a buffer coupled to the feedback path and an output of the second low-pass filter.
Clause 5. The duty correction circuit of clause 4, wherein
   the buffer comprises:
   a first input coupled to the output of the second low-pass filter;
   a second input; and
   an output coupled to the second input.
Clause 6. The duty correction circuit of any of clauses 1 to 5, wherein
   the integration feedback circuit comprises:
   a second capacitor coupled to the second input and an output of the second chopper circuit; and
   a resistor coupled in parallel to the second capacitor.
Clause 7. The duty correction circuit of any of clauses 1 to 6, wherein
   the reference voltage is set based on a target duty cycle of the input clock.

## Claims

1. A duty correction circuit (100a) comprising:
a first capacitor (C1) configured to couple an input clock (CLK_i) to obtain a coupled input clock (CP_CLK);
a buffer chain circuit (110) coupled to the first capacitor (C1) through a node (N1), the buffer chain circuit (110) being configured to output an output clock (CLK_o) based on amplifying the coupled input clock (CP_CLK); and
a feedback circuit (120a) coupled to the node (N1) and the buffer chain circuit (110),
the feedback circuit (120a) including,
a first low-pass filter (121) configured to filter the output clock (CLK_o) to obtain a filtered output clock (CLK_f),
a first chopper circuit (CC1) configured to,
receive a reference voltage (VREF) through a first input (IN1),
receive the filtered output clock (CLK_f) through a second input (IN2), and
chop the reference voltage (VREF) and the filtered output clock (CLK_f) to obtain chopping signals,
an amplifier (AMP) configured to amplify the chopping signals to obtain amplified signals,
a second chopper circuit (CC2) configured to chop the amplified signals,
an integration feedback circuit (IFC) coupled to the second input (IN2) and an output (OUT) of the second chopper circuit (CC2),
a second low-pass filter (123) coupled to the output of the second chopper circuit (CC2), and
a feedback path (FP) configured to provide a filtered signal (FS) from the second low-pass filter (123) to the node (N1).

2. The duty correction circuit (100a) of claim 1, further comprising:
a buffer (124) coupled to the feedback path (FP) and an output of the second low-pass filter (123).

3. The duty correction circuit (100a) of claim 2, wherein
the buffer (124) is a unity gain buffer.

4. The duty correction circuit (100a) of any preceding claim, wherein the buffer chain circuit (110) comprises a plurality of inverters (INV1, INV2).

5. The duty correction circuit (100a) of claim 4, wherein
the plurality of inverters (INV1, INV2) comprises a first inverter (INV1) having an input coupled to the node (N1).

6. The duty correction circuit (100a) of claim 5, wherein
the buffer chain circuit (110) comprises a resistor (R1) coupled to the node (N1) and an output of the first inverter (INV1).

7. The duty correction circuit (110a) of claim 6, further comprising:
a switch (SW1) coupled in series to the resistor (R1), the switch (SW1) being configured to turn on to deactivate the feedback circuit (120a).

8. The duty correction circuit (110a) of any of claims 5-7, wherein
the plurality of inverters (INV1, INV2) comprises at least one second inverter (INV2) coupled in series to an output of the first inverter (INV1).

9. The duty correction circuit (110a) of any of claims 2-8, wherein
the feedback path (FP) comprises:
a switch (SW3) coupled in series to an output of the buffer (124), the switch (SW3) being configured to turn on to activate the feedback circuit (120a); and
a resistor (R3) coupled in series to the switch (SW3).

10. The duty correction circuit (100a) of any preceding claim, further comprising:
a switch (SW2) coupled to the first low-pass filter (121) and the second input (IN2), the switch (SW2) being configured to turn on to activate the feedback circuit (120a).

11. The duty correction circuit (100a) of any preceding claim, wherein the integration feedback circuit (IFC) comprises:
a second capacitor (C2) coupled to the second input (IN2) and an output (OUT) of the second chopper circuit (CC2); and
a resistor (R2) coupled in parallel to the second capacitor (C2).

12. The duty correction circuit (100a) of any preceding claim, wherein the reference voltage (VREF) is set based on a target duty cycle of the input clock (CLK_i).

13. A duty correction circuit (200b) comprising:
a sub-duty correction circuit (210) configured to correct a duty cycle of an input clock (CLK_i) to obtain a corrected input clock (C_CLK);
a buffer chain circuit (220) configured to output an output clock (CLK_o) based on amplifying the corrected input clock (C_CLK); and
a feedback circuit (230) coupled to the sub-duty correction circuit (210) and the buffer chain circuit (220), the feedback circuit (230) including,
a first low-pass filter (231) configured to filter the output clock (CLK_o) to obtain a filtered output clock (CLK_f),
a first chopper circuit (CC1) configured to,
receive a reference voltage (VREF) through a first input (IN1), receive the filtered output clock (CLK_f) through a second input (IN2), chop the reference voltage (VREF) and the filtered output clock (CLK_f) to obtain chopping signals,
an amplifier (AMP) configured to amplify the chopping signals to obtain amplified signals,
a second chopper circuit (CC2) configured to chop the amplified signals, an integration feedback circuit (IFC) coupled to the second input (IN2) and an output (OUT) of the second chopper circuit (CC2),
a second low-pass filter (233) coupled to an output (OUT) of the second chopper circuit (CC2), and
a feedback path (FP) configured to provide a filtered signal (FS) from the second low-pass filter (233) to the sub-duty correction circuit (210).

14. The duty correction circuit (200b) of claim 13, wherein
the sub-duty correction circuit (210) comprises:
a first capacitor (C1) coupled to the feedback path (FP) through a node (N1), the first capacitor (C1) being configured to couple the input clock (CLK_i);
a first inverter (INV1) having an input coupled to the node (N1); and
a resistor (R1) coupled to the node (N1) and an output of the first inverter (INV1).

15. The duty correction circuit (200b) of claim 14, wherein
the buffer chain circuit (220) comprises at least one second inverter (INV2).
